# EUROPÄISCHE PATENTSCHRIFT

(11) **EP 1 198 716 B1**
(45) Veröffentlichungstag und Bekanntmachung des Hinweises auf die Patenterteilung: **08.03.2006**
(21) Anmeldenummer: 00954303.4
(22) Anmeldetag: 30.06.2000
(51) Int. Cl.: G01R 29/10

(54) **SCHALTUNGSANORDNUNG UND VERFAHREN ZUR PRÜFUNG EINES SCHALTDIVERSITY-SYSTEMS**
CIRCUIT ARRANGEMENT AND METHOD FOR VERIFYING A SWITCHING DIVERSITY SYSTEM
CIRCUIT ET PROCEDE POUR LE CONTROLE D'UN SYSTEME A DIVERSITE DE COMMUTATION

(30) Priorität: 07.07.1999 DE 19931252
(43) Veröffentlichungstag der Anmeldung: 24.04.2002
(73) Patentinhaber: ROBERT BOSCH GMBH, 70442 Stuttgart (DE)
(72) Erfinder: RADDANT, Hans-Joachim, D-14055 Berlin (DE)
(86) Internationale Anmeldenummer: PCT/DE2000/002139
(87) Internationale Veröffentlichungsnummer: WO 2001/004649

(56) Entgegenhaltungen:
- EP-A- 0 806 849
- EP-A- 0 816 859
- EP-A- 0 977 044
- DE-A- 4 403 612
- DE-U- 29 911 541
- PATENT ABSTRACTS OF JAPAN vol. 016, no. 574 (E-1298), 14. Dezember 1992 (1992-12-14) -& JP 04 223623 A (FUJITSU TEN LTD), 13. August 1992 (1992-08-13)

## Beschreibung

### Technisches Gebiet

Die Erfindung betrifft eine Schaltungsanordnung und ein Verfahren zur Prüfung eines 5chaltdiversity-Systems.

### Stand der Technik

Schaltdiversity-Antennensysteme sind z.B. in der EP-A-0 201 977 beschrieben. Das aus dieser Druckschrift bekannte System besteht im wesentlichen aus einem Baustein mit Antennenumschaltern und einem Diversity-Prozessor TEA6101 mit ZF-Demodulator TDA1596, beide von Philips. Der Diversity-Prozessor erkennt Empfangsstörungen durch Auswertung eines ZF-Signals, das ihm vom Radio zugeführt wird und schaltet daraufhin mittels des Antennenumschalters auf eine andere Antenne um, deren Signalqualität dann wiederum geprüft wird usw.

Bei diesem System ist es nicht ohne weiteres möglich, bestimmte Antennen zur deren Überprüfung einzuschalten, also mit dem Radioeingangsanschluß zu verbinden.

Eine Schaltungsanordnung, die dieses Problem löst, ist in der DE 195 13 872 A1 angegeben. Unter Bezugnahme auf Fig. 1 wird im folgenden diese Schaltungsanordnung beschrieben. Zum Umschalten zwischen (beispielsweise) vier Antennen 1, 2, 3 und 4 ist ein Antennenumschalter 5 vorgesehen, der von einem Diversity-Prozessor 6 gesteuert wird. An dem Diversity-Prozessor 6 liegen von einem Demodulator 10 erzeugte Steuersignale an, die der Demodulator 10 aus dem ZF-Signal erzeugt, das ein Empfänger (Radio) 8 mit einem oder mehreren Lautsprechern 9 bereitstellt.

Zum permanenten Einschalten bestimmter Antennen ist ein Konverter 51 vorgesehen, der von einem Steuergerät, z.B. dem Radio 8 angesteuert wird. Hierzu erzeugt das Steuergerät ein Digitalsignal, das beispielsweise über das Antennenkabel mit zwischengeschalteter Weiche 52 oder über die zur Steuerung des Diversity-Systems dienende ZF-Leitung zum Konverter 51 übertragen wird; der Konverter 51 wählt mittels elektronischer Schalter eine von z.B. vier Antennen 1, 2, 3 oder 4 aus. Da der Diversity-Prozessor 6 während der Überprüfung der gewählten Antenne nicht abgeschaltet ist, kann es jedoch durch seine Umschaltimpulse zu Störungen des Empfangssignals kommen.

Die in der DE 195 13 872 A1 beschriebene Vorgehensweise hat zwar den Vorteil, daß sie relativ einfach zu realisieren ist. Nachteilig ist jedoch, daß lediglich die Funktion der Antennen, nicht aber die Funktion des Diversity-Prozessors selbst überprüft werden kann, und daß der Diversity-Prozessor während der Überprüfung der Funktion einer Antenne weiter im Betrieb ist.

Die EP 806 849 A2 zeigt ein System mit mehreren Empfangsantennen, einem Diversityprozessor, einem Empfänger sowie einem Signalauswerter. Der Diversityprozessor umfasst einen Antennenumschalter und einen Störungsindikator. Das empfangene Signal wird im Störungsindikator analysiert und bei Störungen ein Steuersignal ausgegeben, welches den Antennenumschalter zur Umschaltung der Empfangsantenne ansteuert. In einem Prüfmodus wird ein Prüfsignal ausgegeben und die Empfangsantennen nacheinander mittels eines Schaltsignals weitergeschaltet. Der Störungsindikator ist dabei abgeschaltet, so dass auch hier die Funktion des Diversity-Prozessors nicht geprüft werden kann.

Die DE 44 03 612 Al zeigt eine Schaltungsanordnung für die Steuerung mehrerer Antennen, mit einem Diversityprozessor und einer Schaltprüfeinrichtung. Dabei werden die Umschaltsignale des Diversityprozessors sowohl dem Antennenumschalter als auch der Schaltprüfeinrichtung zugeführt. Diese ist in der Lage über einen Ausgang den Umschaltvorgang des Diversityprozessors zu stoppen. Damit soll lediglich ein häufiges Umschalten verhindert werden, eine Überprüfung des Systems im Sinne unserer Anmeldung ist nicht vorgesehen.

### Darstellung der Erfindung

Aufgabe der Erfindung ist es, eine Schaltungsanordnung und ein Verfahren zur Prüfung eines Schaltdiversity-Systems anzugeben, mit dem nicht nur die Antennen auf ihre Funktion überprüfbar sind, sondern auch der Diversity-Prozessor selbst.

Insbesondere soll die erfindungsgemäße Schaltungsanordnung und das erfindungsgemäße Verfahren verhindern, daß der Prozessor während der Diagnose Umschaltsignale erzeugt, die die Funktionsüberprüfung stören.

Eine erfindungsgemäße Schaltungsanordnung ist im Patentanspruch 1 angegeben. Ein erfindungsgemäßen Verfahren beschreibt Anspruch 9. Weiterbildungen der Erfindung sind Gegenstand der abhängigen Ansprüche.

Erfindungsgemäß ist ein Diagnoseprozessor vorgesehen, der einen mit einem Steuereingang des Diversity-Prozessors verbundenen Ausgangsanschluß aufweist, und der an seinem Ausgangsanschluß ein Signal bereitstellt, das weitere Umschaltvorgänge durch den Diversityprozessor verhindert.

Insbesondere kann dabei eine Eigenschaft bekannter Diversity-Prozessoren, wie beispielsweise des Schaltkreises TEA6101 der Fa. Philips ausgenutzt werden. Dieser Diversity-Prozessor ist beispielsweise in der Lage, das Weiterschalten auf eine andere Antenne zu unterbrechen, wenn an seinem "Control"-Eingang ein Stoppsignal angelegt wird.

Der erfindungsgemäß vorgesehene Diagnose-Prozessor erzeugt dieses Stoppsignal in genau dem Moment, in dem er erkennt, daß die gewählte Antenne durch den Diversity-Prozessor eingeschaltet worden ist. Anders ausgedrückt, wird erfindungsgemäß zur Diagnose nicht eine zusätzliche Steuerungeinheit für den Antennenumschalter verwendet, sondern der Diversity-Prozessor geeignet angesteuert, so daß dieser unabhängig vom momentanen Antennensignal ständig die gewählte Antenne einschaltet.

Nur klarstellend soll darauf hingewiesen, daß mit dem Begriff "Prozessor" nicht impliziert wird, daß es sich bei diesem Schaltkreis um einen Mikroprozessor oder einen Mikrocontroller handeln muß. Anstelle derartiger Prozessoren können selbstverständlich auch "festverdrantete" Schaltkreise eingesetzt werden.

Die Diagnose kann mit der erfindungsgemäßen Schaltungsanordnung beispielsweise wie folgt durchgeführt werden:
1. Zunächst wird am Radio eine Frequenz eingestellt, bei der ein relativ schwaches Signal empfangen wird. Dies ist notwendig, weil der Diversity-Prozessor die Antenne nur innerhalb des Empfangspegelbereichs umschaltet, bei dem Rauschen im Lautsprecher hörbar wird.
2. Danach oder vorher wird am Radio die Nummer der einzustellenden Antenne eingegeben. Diesen Wert überträgt das Radio zum Diagnose-Prozessor.
3. Vorhandene Empfangssignalschwankungen oder solche, die z.B. durch Berühren der Antenne hervorgerufen werden, veranlassen den Diversity-Prozessor, auf eine andere Antenne umzuschalten. Wenn der Diagnose-Prozessor beispielsweise mittels eines Vergleichers erkennt, daß die gewünschte Antenne eingestellt ist, setzt er das Stoppsignal für den Diversity-Prozessor. Das Erreichen dieses Zustandes wird an das Radio zurückübertragen und dort angezeigt.
4. Der Diversity-Prozessor kann als grundsätzlich funktionsfähig angesehen werden, wenn eine Weiterschaltung auf eine andere Antenne erfolgt ist. Eine Überprüfung der Antenne selbst, z.B. ein Hörtest, kann anschließend durchgeführt werden.

Sollte eine eingehendere Prüfung des Systems, z.B. als Endkontrolle bei der Fertigung, notwendig sein, kann durch Verwendung von bekannten Testsignalen sowohl die Diversity-Schaltschwelle als auch die Funktion der Antenne geprüft werden.

Auch die Richtcharakteristik der einzelnen Antennen ist überprüfbar, wenn die Verbindung zwischen Antennenkabel und Radioeingang aufgetrennt wird und das Antennenausgangssignal einem Meßempfänger zugeführt wird.

Bei einer weiteren Ausführungsform ist es möglich, daß eine Umschaltung auf die nächste Antenne während der Diagnose durch besondere Schaltungsmaßnahmen hervorgerufen wird. Dies kann z.B. dadurch erfolgen, daß der Diversity-Prozessor durch kurzzeitiges Abschalten aller Antennen zum Weiterschalten veranlaßt wird. Diese Maßnahme ist am einfachsten direkt am Antennenumschalter am Sammelpunkt der Schaltdioden durchführbar.

Ferner ist es möglich, daß das "Level"-Signal des Demodulators zur genaueren Beurteilung des Empfangspegels der Antenne herangezogen wird. Die Größe dieses Signals ist im für den Diversity-Betrieb relevanten Bereich dem Empfangspegel weitgehend proportional und kann deshalb bei der Prüfung mit einem Referenz-Signal verglichen werden.

In einer weiteren Ausführungsform kann statt des Radios als Steuergerät für den Diagnose-Prozessor auch ein besonderes, nur für diesen Zweck angefertigtes Prüfgerät verwendet werden.

### Kurze Beschreibung der Zeichnung

Die Erfindung wird nachstehend ohne Beschränkung des allgemeinen Erfindungsgedankens anhand von Ausführungsbeispielen unter Bezugnahme auf die Zeichnung exemplarisch beschrieben, auf die im übrigen hinsichtlich der Offenbarung aller im Text nicht näher erläuterten erfindungsgemäßen Einzelheiten ausdrücklich verwiesen wird:
- Fig. 1: ein 4-Antennen-Diversitysystem mit Diagnose nach dem Stand der Technik,
- Fig. 2: ein Ausführungsbeispiel eines erfindungsgemäßen 4-Antennen-Diversitysystems mit Diagnose,
- Fig. 3a: den Aufbau eines ersten Ausführungsbeispiels eines erfindungsgemäßen Diagnose-Prozessors,
- Fig. 3b: ein zweites Ausführungsbeispiel eines Diagnose-Prozessors mit der Möglichkeit, alle Antennen gleichzeitig abzuschalten,
- Fig. 3c: ein drittes Ausfuhrungebeispiel eines Diagnose-Prozessors mit der Möglichkeit, den ZF-Signalpegel zu bewerten,
- Fig. 3d: ein weiteres Ausftlhrungebeispiel des DiagnoseProzessors mit der Möglichkeit, sowohl alle Antennen gleichzeitig abzuschalten als auch den ZF-Signalpegel zu bewerten,
- Fig. 4: ein Ausführungsbeispiel für einen Antennenumschalter mit der Möglichkeit, alle Antennen gemeinsam abzuschalten, und
- Fig. 5: ein 4-Antennen-Diversitysystem mit Diagnose und Übertragung der Prüfsignale über die ZF-Leitung.

### Darstellung von Ausführungsbeispielen

In den folgenden Figuren sind gleiche Teile immer mit den selben Bezugszeichen versehen, so daß auf eine erneute Vorstellung dieser Teile bei der Erläuterung weiterer Figuren verzichtet wird.

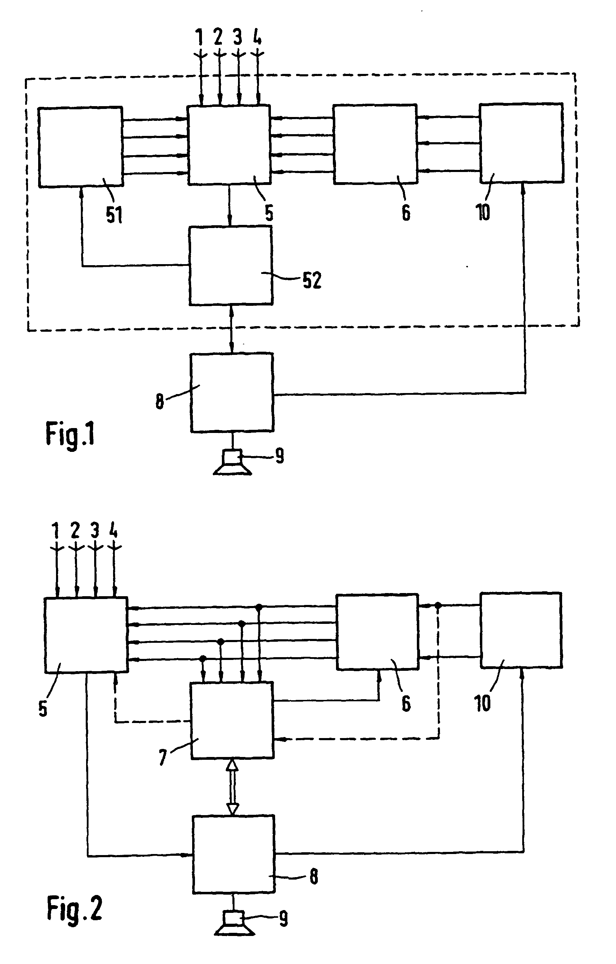

Fig. 2 zeigt als Blockschaltbild ein Ausführungsbeispiel eines Antennen-Diversitysystems mit Diagnose. Vier Antennen 1 bis 4 sind an einen Antennenumschalter 5 angeschlossen, der von einem Diversity-Prozessor 6 angesteuert wird, und der entsprechend der Ansteuerung das Signal einer bestimmten Antenne an seinen Ausgangsanschluß "durchschaltet". Das an diesem Ausgangsanschluß anstehende Ausgangssignal (HF-Signal) des Antenennenumschalters 5 ist an ein Radio 8 mit wenigstens einem Lautsprecher 9 angelegt, mit dem u.a. auch eine akustische Bewertung möglich ist.

Erfindungsgemäß ist ein Diagnose-Prozessor 7 vorgesehen, dessen Funktion im folgenden erläutert wird.

Der Diagnose-Prozessor 7 hat Eingangsanschlüsse für die (bei dem gezeigten Ausführungsbeispiel) vier Schaltleitungen für den Antennenumsctialter 5, einen Ein/Ausgangsanschluß für digitale Prüfsignale sowie (optional) einen weiteren Eingangsanschluß, dessen Funktion nachstehend noch erläutert werden wird.

Das von dem Empfänger 8 erzeugte ZF-Signal ist über ein Koaxialkabel an einen Demodulator 10 angelegt. Der Demodulator 10 erzeugt aus dem ZF-Signal intern die Signale "Level" und "Audio", die an den Diversity-Prozessor 6 angelegt sind. Das Level-Signal, das auch an den weiteren Eingangsanschluß des Diagnose-Prozessors 7 angelegt ist, stellt ein dem ZF-Signalpegel proportionales Gleichspannungssignal dar und erlaubt die Bewertung des Empfangspegels. Das Audio-Signal ist der Modulationsinhalt des Rundfunksignals.

Ferner kann der Diagnose-Prozessor 7 einen Ausgangsanschluß ausweisen, an dem ein Signal anliegt, mit dem alle Antennen abgeschaltet werden können.

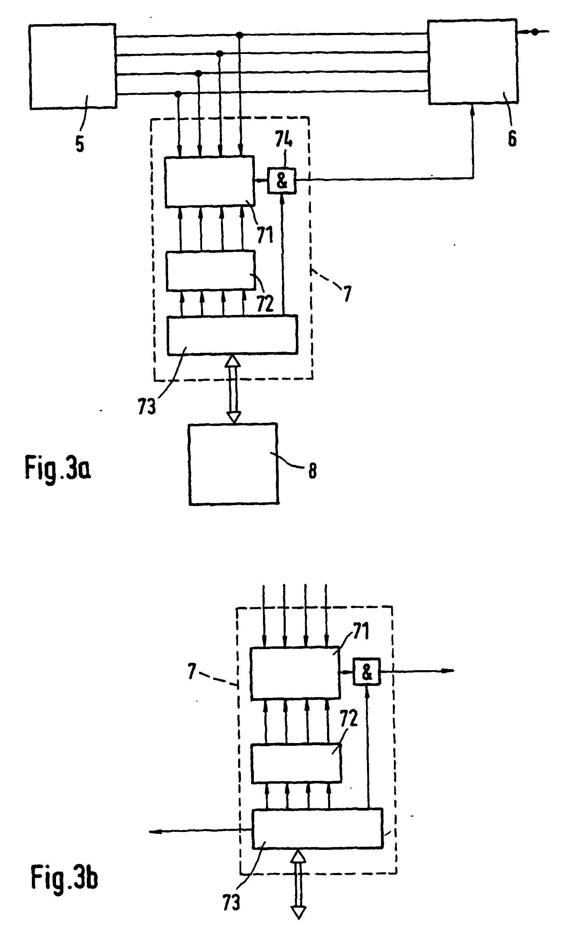

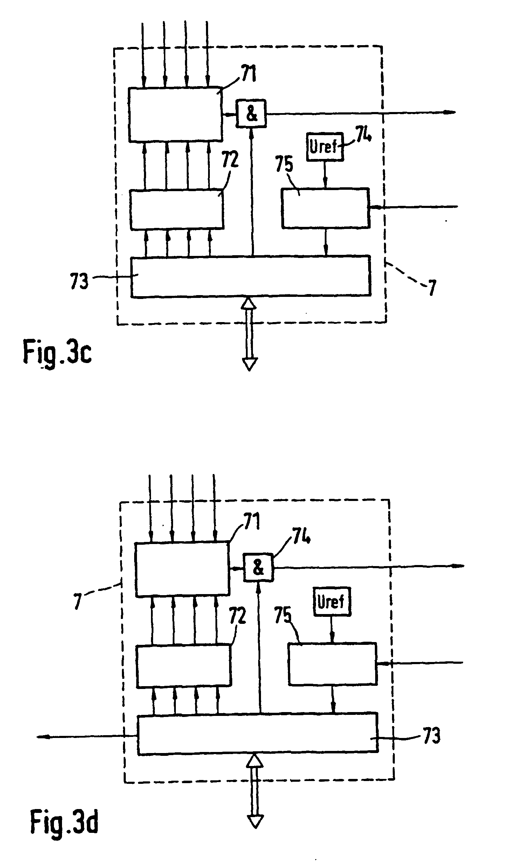

Die Funktionsweise des erfindungsgemäß vorgesehenen Diagnose-Prozessors 7 wird im folgenden unter Bezugnahme auf die Figuren 3 näher erläutert. Dabei sind die gleichen Teile wie in Fig. 2 mit den selben Bezugszeichen versehen, so daß auf eine erneute Vorstellung verzichtet werden kann.

Fig. 3a zeigt ein erstes Ausführungsbeispiel für den Diagnose-Prozessor 7:

Die (bei dem gezeigten Ausführungsbeispiel) vier Antennenschaltleitungen sind zu einem Vergleichsglied 71 geführt. Die Vergleichseingangsanschlüsse des Vergleichsgliedes 71 sind mit einem Register 72 verbunden, das die Nummer der für die Diagnose einzustellenden Antenne 1, 2, 3 oder 4 speichert. Die Nummer der Antenne wird vom Radio 8 über ein Interface 73 an die Vergleichseingangsanschlüsse des Registers 72 übertragen. Das Interface 73 stellt ferner ein Diagnose-Freigabesignal bereit, das zusammen mit dem Ausgangssignal des Vergleichsgliedes 71 an einem UND-Glied 74 als Eingangssignal anliegt, dessen Ausgangssignal als Stoppsignal an dem Steuereingangsanschluß des Diversity-Prozessors 6 anliegt.

Fig. 3b zeigt eine Modifikation des in Fig. 3a gezeigten Ausführungsbeispiels, bei der das Interface 73 über einen Ausgangsanschluß verfügt, an dem ein Signal anliegt, mit dem alle Antennen 1..4 abgeschaltet werden können. Diese Eigenschaft kann verwendet werden, wenn die Umschaltung zur nächsten Antenne nicht durch eine schlechte Signalqualität des Empfangssignals hervorgerufen werden soll oder kann, sondern gezielt zu einem bestimmten Zeitpunkt durch das Steuergerät.

Bei dem in Fig. 3c dargestellten Ausführungsbeispiel liegen an dem Interface 73 ferner neben den vom Radio 8 erzeugten Prüfsignalen auch das Ausgangssignal eines Fensterkomparators 75 an, der das "Level"-Signal mit einer Referenzspannung U_{rof} vergleicht. Diese Eigenschaft kann verwendet werden, wenn das Diversity-System beim Automobilhersteller während der Fertigung des Fahrzeugs mit definierten frequenzmodulierten HF-Testsignalen überprüft werden soll.

Fig. 3d zeigt ein Ausführungsbeispiel, das über die Eigenschaften sowohl des in Fig. 3b als auch des in Fig. 3c gezeigten Ausführungsbeispiels verfügt.

Selbstverständlich ist eine Erweiterung der gezeigten Schaltung auf mehr oder weniger als vier Antennen jederzeit möglich.

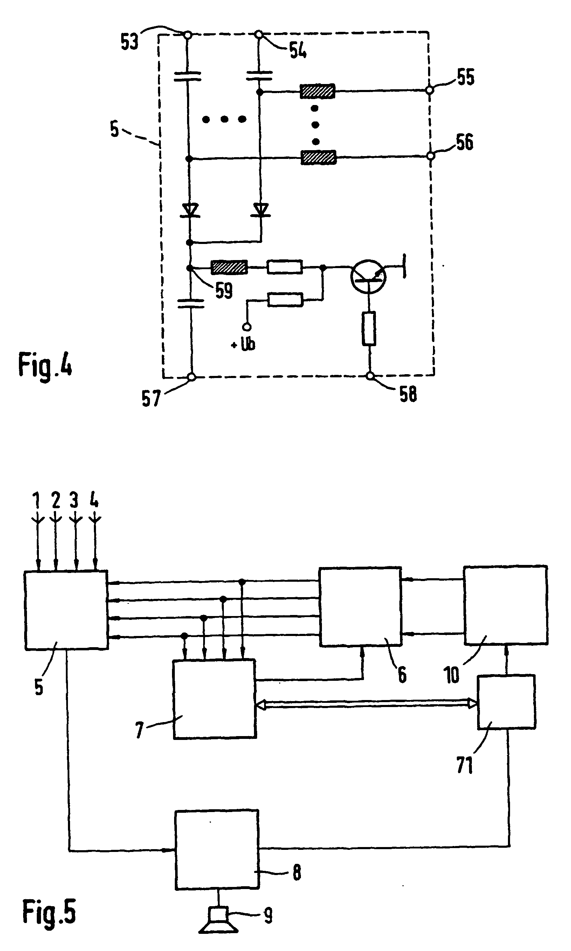

Fig. 4 zeigt ein Ausführungsbeispiel für einen Antennenumschalter 5, der das Abschalten aller Antennen gleichzeitig erlaubt. Ohne Beschränkung des allgemeinen Aufbau weist der dargestellte Antennenumschalter 5 zwei Eingangsanschlüsse 53 und 54 auf, die in Abhängigkeit von an den Anschlüssen 55 und 56 anliegenden Schaltsignalen mit einem Radio-Ausgangsanschluß 57 verbunden sind. Mit 58 ist ein Abschalteingangsanschluß bezeichnet. Liegt an dem Anschluß 58 ein Steuersignal mit Null-Potential an, wird der Schaltungspunkt 59 wegen des abgeschalteten Transistors mit der Plusspannung +Ub verbunden, so daß die Schaltdioden keinen Strom mehr führen können und am Anschluß 57 kein Signal mehr ansteht. Damit ist es möglich, mit einem einzigen Signal alle Antennen abzuschalten.

Fig. 5 zeigt eine Modifikation des in Fig. 2 gezeigten Ausführungsbeispiels, bei dem zur Reduzierung des Verkabelungsaufwandes die Prüfsignale über das ZF-Kabel geführt werden. Dies ermöglichen zwei Frequenzweichen an Radio- und Prozessorseite die Ein- und Auskopplung, von denen in Fig. 5 lediglich die prozessorseitige Weiche 71 dargestellt ist. Die Frequenzweiche an der Radioseite ist nicht dargestellt, da sie sich innerhalb des Radios befindet. Eine Verwendung des HF-Antennenkabels für diesen Zweck ist nicht sinnvoll, da dies gegebenenfalls vom Radio abgezogen werden muß, wenn zum Beispiel die Richtdiagramme der Antennen gemessen werden sollen. Dann wird das Antennenkabel mit einem Meßempfänger verbunden. Wenn unter diesen Umständen weiterhin eine Steuerung der Antennen bzw. das Einschalten einer bestimmten Antenne möglich sein soll, müssen die Steuersignale auf einem anderen Kabel als dem HF-Signal-Kabel vom Radio zur Diversity-Schaltung übertragen werden.

## Patentansprüche

1. Schaltungsanordnung zur Prüfung eines Rundfunkempfangssystems, das
- mehrere Antennen (1, 2, 3, 4),
- einen Antennenumschalter (5) für die Antennen,
- einen Empfänger (8), und
- einen Diversity-Prozessor (6) aufweist, der den Antennenumschalter steuert,
**gekennzeichnet durch** einen Diagnoseprozessor mit einem Eingang für Steuersignale des Diversity-Prozessors (6), die sowohl dem Antennenumschalter (5) als auch dem Diagnoseprozessor (7) zugeführt sind, und einem mit einem Steuereingang des Diversity-Prozessors (6) verbundenen Ausgangsanschluß, an dem der Diagnoseprozessor (7) ein Signal bereitstellt, das weitere Umschaltvorgänge **durch** den Diversity-Prozessor verhindert, wenn der Diagnoseprozessor aus den Steuersignalen erkennt, dass eine bestimmte, für die Prüfung gewählte Antenne **durch** den Diversity-Prozessor (6) eingeschaltet worden ist.

2. Schaltungsanordnung nach Anspruch 1, **dadurch gekennzeichnet**, die bestimmte Antenne vorwählbar ist.

3. Schaltungsanordnung nach Anspruch 2, **dadurch gekennzeichnet, dass** der Diagnoseprozessor Eingangsanschlüsse aufweist, an denen die Steuersignale des Diversity-Prozessors (6) für den Antennenumschalter (5) anliegen.

4. Schaltungsanordnung nach Anspruch 2 oder 3, **dadurch gekennzeichnet, dass** der Empfänger (8) an den Diagnoseprozessor (7) ein Signal anlegt, durch das die bestimmte Antenne ausgewählt wird.

5. Schaltungsanordnung nach Anspruch 4, **dadurch gekennzeichnet, dass** am Empfänger (8) die Nummer der gewählten Antenne (1, 2, 3, 4) eingebbar ist.

6. Schaltungsanordnung nach einem der Ansprüche 3 bis 5, **dadurch gekennzeichnet, dass** der Diagnoseprozessor (7) ein Vergleichsglied (71) aufweist, an dem die Steuersignale der Antennen-Umschaltleitungen und Ausgangssignale eines Registers (62) anliegen, die die Nummer der bestimmten, für die Prüfung einzustellenden Antenne angeben.

7. Schaltungsanordnung nach Anspruch 6, **dadurch gekennzeichnet, dass** Prüfsignale, insbesondere die Nummer der bestimmten Antenne zusammen mit einem Diagnose-Freigabesignal, vom Empfänger (8) übertragen werden.

8. Schaltungsanordnung nach Anspruch 7, **dadurch gekennzeichnet, dass** die Prüfsignale über das ZF-Kabel geführt werden, wobei zwei Frequenzweichen empfängerseitig und diagnoseprozessorseitig die Ein- und Auskopplung ermöglichen.

9. Verfahren zur Prüfung eines Rundfunkempfangssystems, das
- mehrere Antennen (1, 2, 3, 4),
- einen Antennenumschalter (5) für die Antennen,
- einen Empfänger (8), und
- einen Diversity-Prozessor (6) aufweist, der den Antennenumschalter steuert,
unter Verwendung einer Schaltungsanordnung nach einem der Ansprüche 1 bis 8
mit folgenden Schritten:
- am Empfänger (8) wird eine Frequenz eingestellt, bei der ein relativ schwaches Signal empfangen wird,
- eine bestimmte Antenne (1..4) wird gewählt,
- der Diversity-Prozessor (6) wird veranlasst, die Antennen umzuschalten,
- sobald der Diversity-Prozessor auf die bestimmte Antenne umgeschaltet hat, werden weitere Umschaltvorgänge verhindert und das Umschalten auf die bestimmte Antenne angezeigt.

10. Verfahren nach Anspruch 9, **dadurch gekennzeichnet, dass** der Diversity-Prozessor durch vorhandene Empfangssignalschwankungen oder Schwankungen, die z.B. durch Berühren einer Antenne hervorgerufen werden, veranlasst wird, auf eine andere Antenne umzuschalten.

11. Verfahren nach Anspruch 9 oder 10, **dadurch gekennzeichnet, dass** bekannte Testsignale zur Prüfung sowohl der Diversity-Schaltschwelle als auch der Funktion der bestimmten Antenne verwendet werden.

12. Verfahren nach Anspruch 11, **dadurch gekennzeichnet, dass** die Richtcharakteristik der einzelnen Antennen **dadurch** überprüft wird, dass auf die zu überprüfende Antenne geschaltet und anschließend die Verbindung zwischen Antennenkabel und Empfängereingang aufgetrennt wird, und das Antennenkabel an einen Meßempfänger angelegt wird.

13. Verfahren nach einem der Ansprüche 9 bis 12, **dadurch gekennzeichnet, dass** eine Umschaltung auf die nächste Antenne durch den Diversity-Prozessor durch kurzzeitiges Abstellen aller Antennen direkt am Antennenumschalter am Sammelpunkt der Schaltdioden veranlasst wird.

14. Verfahren nach einem der Ansprüche 9 bis 13, **dadurch gekennzeichnet, dass** dem Demodulator (10) ein vom Empfänger (8) erzeugtes ZF-Signal zugeführt wird, aus dem der Demodulator (10) ein Level-Signal erzeugt, und dass das Level-Signal des Demodulators zur genaueren Beurteilung des Empfangspegels der bestimmten Antenne herangezogen wird, indem seine Größe, welche im für den Diversity-Betrieb relevanten Bereich dem Empfangspegel weitgehend proportional ist, mit einem Referenzsignal verglichen wird.

15. Verfahren nach einem der Ansprüche 9 bis 14, **dadurch gekennzeichnet, dass** der Empfänger (8) als Prüfgerät ausgebildet ist, das als Steuergerät für den Diagnoseprozessor (7) verwendet wird.

## Claims

1. Circuit arrangement for testing a broadcast radio receiving system, which has
- a plurality of antennas (1, 2, 3, 4),
- an antenna switch (5) for the antennas,
- a receiver (8), and
- a diversity processor (6) which controls the antenna switch,
**characterized by** a diagnosis processor having an input for control signals for the diversity processor (6), which control signals are supplied both to the antenna switch (5) and to the diagnosis processor (7), and having an output connection which is connected to a control input of the diversity processor (6) and at which the diagnosis processor (7) produces a signal which prevents further switching processes by the diversity processor when the diagnosis processor finds from the control signals that a specific antenna, which has been chosen for the test, has been switched on by the diversity processor (6).

2. Circuit arrangement according to Claim 1, **characterized in that** the specific antenna can be preselected.

3. Circuit arrangement according to Claim 2, **characterized in that** the diagnosis processor has input connections at which the control signals of the diversity processor (6) for the antenna switch (5) are present.

4. Circuit arrangement according to Claim 2 or 3, **characterized in that** the receiver (8) applies a signal to the diagnosis processor (7); by means of which the specific antenna is selected.

5. Circuit arrangement according to Claim 4, **characterized in that** the number of the selected antenna (1, 2, 3, 4) can be entered at the receiver (8).

6. Circuit arrangement according to one of Claims 3 to 5, **characterized in that** the diagnosis processor (7) has a comparison element (71) at which the control signals of the antenna switching lines and the output signals from a register (62) are present, and indicate the number of the specific antenna to be selected for the test.

7. Circuit arrangement according to Claim 6, **characterized in that** test signals, in particular the number of the specific antenna, are transmitted together with a diagnosis enable signal from the receiver (8).

8. Circuit arrangement according to Claim 7, **characterized in that** the test signals are passed via an IF cable, with two frequency splitters allowing inputting and outputting at the receiver end and at the diagnosis processor end.

9. Method for testing a broadcast radio receiving system, which has
- a plurality of antennas (1, 2, 3, 4),
- an antenna switch (5) for the antennas,
- a receiver (8), and
- a diversity processor (6) which controls the antenna switch,
using a circuit arrangement according to one of Claims 1 to 8,
and comprising the following steps:
- a frequency at which a relatively weak signal is received is selected at the receiver (8),
- one specific antenna (1...4) is selected,
- the diversity processor (6) is caused to switch the antennas,
- as soon as the diversity processor has switched to the specific antenna, further switching processes , are prevented, and the switching to the specific antenna is indicated.

10. Method according to Claim 9, **characterized in that** the diversity processor is caused to switch to a different antenna by any received signal fluctuations which may be present or by fluctuations which are caused, for example, by an antenna being touched.

11. Method according to Claim 9 or 10, **characterized in that** known test signals are used for testing both the diversity switching threshold and the operation of the specific antenna.

12. Method according to Claim 11, **characterized in that** the directionality of the individual antennas is checked by switching to the antenna to be checked and by then disconnecting the connection between the antenna cable and the receiver input, with the antenna cable being connected to a measurement receiver.

13. Method according to one of Claims 9 to 12, **characterized in that** switching to the next antenna is caused by the diversity processor by briefly disconnecting all of the antennas directly at the antenna switch at the junction point of the switching diodes.

14. Method according to one of Claims 9 to 13, **characterized in that** an IF signal which is produced by the receiver (8) is supplied to the demodulator (10) and is used by the demodulator (10) to produce a level signal, and **in that** the level signal from the demodulator is used for more accurate assessment of the reception level of the specific antenna **in that** its magnitude (which is largely proportional to the reception level in the range which is relevant for diversity operation) is compared with a reference signal.

15. Method according to one of Claims 9 to 14, **characterized in that** the receiver (8) is in the form of a test set, and is used as a controller for the diagnosis processor (7).

## Revendications

1. Circuit pour le contrôle d'un système de réception radio, qui présente
- plusieurs antennes (1, 2, 3, 4),
- un commutateur d'antenne (5),
- un récepteur (8), et
- un processeur à diversité (6), qui commande le commutateur d'antenne,
**caractérisé par**
un processeur de diagnostic ayant une entrée pour des signaux de commande du processeur à diversité (6) envoyés aussi bien au commutateur d'antenne (5) qu'au processeur de diagnostic (7), et une borne de sortie raccordée à une entrée de commande du processeur à diversité (6), et qui reçoit du processeur de diagnostic (7) un signal qui empêche d'autres opérations de commutation via le processeur à diversité, lorsque le processeur de diagnostic reconnaît à partir des signaux de commande qu'une antenne déterminée choisie pour le contrôle a été activée par le processeur à diversité (6).

2. Circuit selon la revendication 1,
**caractérisé en ce que**
l'antenne déterminée peut être présélectionnée.

3. Circuit selon la revendication 2,
**caractérisé en ce que**
le processeur de diagnostic comporte des bornes d'entrée qui présentent les signaux de commande du processeur à diversité (6) pour le commutateur d'antenne (5).

4. Circuit selon la revendication 2 ou 3,
**caractérisé en ce que**
le récepteur (8) applique au processeur de diagnostic (7) un signal sélectionnant l'antenne déterminée.

5. Circuit selon la revendication 4,
**caractérisé en ce que**
le numéro de l'antenne choisie (1, 2, 3, 4) peut être introduit dans le récepteur (8).

6. Circuit selon l'une quelconque des revendications 3 à 5,
**caractérisé en ce que**
le processeur de diagnostic (7) présente un élément de comparaison (71) qui reçoit les signaux de commande des lignes de commutation d'antenne et des signaux de sortie d'un registre (62) qui indiquent le numéro de l'antenne déterminée à régler pour le contrôle.

7. Circuit selon la revendication 6,
**caractérisé en ce que**
des signaux de contrôle, en particulier le numéro de l'antenne déterminée, sont transmis par le récepteur (8) en même temps qu'un signal de libération de diagnostic.

8. Circuit selon la revendication 7,
**caractérisé en ce que**
les signaux de contrôle sont conduits par le câble FI, avec deux filtres de fréquence permettant le couplage et le découplage du côté du récepteur et du côté du processeur de diagnostic.

9. Procédé pour le contrôle d'un système de réception radio, qui présente
- plusieurs antennes (1, 2, 3, 4),
- un commutateur d'antenne (5) pour les antennes,
- un récepteur (8), et
- un processeur à diversité (6), qui commande le commutateur d'antenne,
avec utilisation d'un circuit selon l'une quelconque des revendications 1 à 8, comportant les étapes suivantes :
- au niveau du récepteur (8), on règle une fréquence à laquelle on reçoit un signal relativement faible,
- on choisit une antenne déterminée (1, ..., 4),
- on donne au processeur à diversité l'instruction de commuter les antennes, et
- dès que le processeur à diversité est commuté sur l'antenne déterminée, on empêche d'autres opérations de commutation et on affiche la commutation sur l'antenne déterminée.

10. Procédé selon la revendication 9,
**caractérisé en ce que**
pour des fluctuations existantes du signal de réception ou des fluctuations provoquées par exemple par contact d'une antenne, on autorise le processeur à diversité à commuter sur une autre antenne.

11. Procédé selon la revendication 9 ou 10,
**caractérisé en ce qu'**
on utilise des signaux de test connus pour le contrôle aussi bien du seuil de commutation en diversité que du fonctionnement de l'antenne déterminée.

12. Procédé selon la revendication 11,
**caractérisé en ce que**
la caractéristique directionnelle des antennes individuelles est contrôlée en commutant sur l'antenne à contrôler et ensuite en coupant la liaison entre le câble d'antenne et l'entrée du récepteur, et on applique le câble d'antenne à un récepteur de mesure.

13. Procédé selon l'une quelconque des revendications 9 à 12,
**caractérisé en ce qu'**
une commutation sur l'antenne suivante par le processeur à diversité est autorisée par une brève coupure de toutes les antennes directement au niveau du commutateur d'antenne au point de jonction des diodes de commutation.

14. Procédé selon l'une quelconque des revendications 9 à 13,
**caractérisé en ce qu'**
on amène au démodulateur (10) un signal FI produit par le récepteur (8), et à partir du signal ZF le démodulateur (10) produit un signal de niveau utilisé pour une appréciation plus précise du niveau de réception de l'antenne déterminée, en comparant avec un signal de référence l'amplitude du signal de niveau qui est largement proportionnelle au niveau de réception dans le domaine concerné pour le fonctionnement en diversité.

15. Procédé selon l'une quelconque des revendications 9 à 14,
**caractérisé en ce que**
le récepteur (8) est un appareil de contrôle utilisé comme appareil de commande pour le processeur de diagnostic (7).
